# EUROPEAN PATENT APPLICATION

(11) **EP 3 091 475 A1**
(43) Date of publication of application: **09.11.2016**
(21) Application number: 14858977.3
(22) Date of filing: 13.06.2014
(51) Int. Cl.: G06K 7/10, G06K 9/18

(54) **BARCODE ENGINE**

(30) Priority: 29.10.2013 KR 20130129057
(71) Applicant: Park, Jin Suk, Seoul 150-754 (KR); Oh, Seok Whan, Seoul 150-754 (KR)
(72) Inventor: Park, Jin Suk, Seoul 150-754 (KR); Oh, Seok Whan, Seoul 150-754 (KR)
(74) Representative: TBK
(86) International application number: PCT/KR2014/005212
(87) International publication number: WO 2015/064879

(57) **Abstract**

The present disclosure relates to a barcode engine. The barcode engine comprises an imaging part that has a plurality of openings, obtains an image of a barcode by taking a picture thereof, and outputs a corresponding image signal; a decoding part that has a plurality of first openings, is located under the imaging part and interprets information contained in the barcode using the image signal output from the imaging part; and a plurality of guide pins that are inserted into or abut the plurality of first openings formed in the decoding part and that are inserted into or abut the plurality of openings formed in the imaging part, thereby stacking the imaging part on top of the decoding part in a vertical direction.

## Description

### FIELD

The present disclosure relates to a barcode engine.

### BACKGROUND

A barcode is a signal system that expresses information using a pattern formed by combining black and white bars of different thicknesses.

Since such a barcode enables data to be correctly input and allows a convenient use, the barcode is being widely used in various fields including production management and sales management of products.

A barcode reading device is a device that optically reads the barcode, and reads the information of the barcode using an electronic signal generated depending on the intensity of light that is radiated onto and reflected from the barcode printed on a product or the like.

Generally, the barcode reading device comprises a barcode engine that is composed of an imaging part and a decoding part.

The imaging part is a part that obtains an image of the barcode using light radiated onto and reflected from the barcode and then converts the image into an electrical image signal. The decoding part is a part that decodes information stored in the barcode using an image signal corresponding to the obtained image.

In a conventional case, the imaging part and the decoding part are designed as separate modules and are connected to each other via a flexible cable.

When manufacturing the barcode engine having the imaging part and the decoding part that are separate from each other, and the flexible cable, it is difficult to reduce a size of the barcode engine due to a space occupied by the flexible cable even if the imaging part and the decoding part are arranged side by side.

Therefore, since it is difficult to reduce the size of the barcode engine that is the most important element of the barcode reading device, it is difficult to realize the miniaturization of the barcode reading device.

### SUMMARY

Accordingly, the present disclosure is intended to realize a reduction in size of a barcode engine.

The present disclosure is intended to improve a barcode reading function.

In an embodiment, the present disclosure comprises a barcode engine including an imaging part having a plurality of openings and obtaining an image of a barcode by taking a picture thereof to output a corresponding image signal; a decoding part having a plurality of first openings, located under the imaging part and interpreting information contained in the barcode using the image signal output from the imaging part; and a plurality of guide pins inserted into or abutting the plurality of first openings formed in the decoding part, and inserted into or abutting the plurality of openings formed in the imaging part, thereby stacking the imaging part on top of the decoding part in a vertical direction.

The plurality of guide pins, the plurality of openings of the imaging part and the plurality of first openings of the decoding part coming into contact with the plurality of guide pins, respectively, may be plated with gold, thus sending an electrical signal between the imaging part and the decoding part.

The imaging part may comprise an imaging module located above the decoding part, the imaging module having a plurality of second openings at positions corresponding to the plurality of first openings of the decoding part, and outputting the image of the barcode in a form of the image signal; a housing located above the imaging module, the housing having a plurality of third openings at positions corresponding to the plurality of second openings of the imaging module, and protecting the imaging module; and a light-emitting diode module located above the housing, the light-emitting diode having a plurality of fourth openings at positions corresponding to the plurality of third openings of the housing, and outputting illumination to the barcode. The plurality of guide pins may pass through the plurality of first to fourth openings to sequentially stack the imaging module, the housing, and the light-emitting diode module on the decoding part in a vertical direction.

The plurality of guide pins may have different diameters, and may comprise a plurality of portions serving as an insert prevention step of the imaging module and the light-emitting diode module.

The decoding part, the imaging module, the housing, and the light-emitting diode module may be equal to each other in width and in length.

The light-emitting diode module may comprise a plurality of light-emitting-diode parts, and each of the plurality of light-emitting-diode parts may comprises a plurality of light emitting diodes that radiate red, green, and blue light, respectively.

The light-emitting diode module may turn on at least one of the plurality of light emitting diodes that radiate the red, green, and blue light.

The imaging module may comprise a laser diode part to radiate a laser beam, and the imaging part may further comprise a diffractive-optical-element pattern part that is located above the laser diode part and outputs the laser beam, outputted from the laser diode part, in a preset aiming pattern.

The aiming pattern may comprise four bracket marks shown by solid lines on two corners that diagonally face each other, among four corners of a tetragon; and one cross mark formed by solid lines at a central portion in a rectangular area that is imaginarily surrounded by the four bracket marks.

As is apparent from the above description, the barcode engine of the present disclosure is advantageous in that the decoding part and the imaging part of the substantially same size are assembled in the vertical direction using a plurality of guide pins, so that the size of the barcode engine is considerably reduced. Further, the plurality of guide pins is plated to serve as a signal transmission line for transmitting a signal, and the signal transmission between the decoding part and the imaging part is implemented by a stacking structure, so that a separate flexible cable for transmitting the signal is omitted and thereby the size of the barcode engine is further decreased.

Further, the barcode engine of the present disclosure is advantageous in that the color of the light emitting diode radiated onto the barcode may be selected depending on a material of a part on which the barcode is printed, so that it is possible to obtain a clearer and more correct barcode image and thereby the barcode reading function is improved.

### BRIEF DESCRIPTION OF THE DRAWINGS

FIG. 1 is an exploded perspective view illustrating a barcode engine according to an embodiment of the present disclosure;
FIG. 2 is view illustrating an example of an aiming pattern of a laser beam that is output from a diffractive-optical-element pattern part of FIG. 1; and
FIG. 3 is an exploded perspective view illustrating a barcode engine according to another embodiment of the present disclosure.

### DETAILED DESCRIPTION

Hereinafter, embodiments of the present disclosure will be described in detail with reference to the accompanying drawings to allow those skilled in the art to easily practice the disclosure. However, the present disclosure may be implemented in various different forms and is not limited to the embodiments that are described herein. For the clarity of description, some parts may be omitted in the drawings. Like reference numerals are used to identify like elements throughout the drawings.

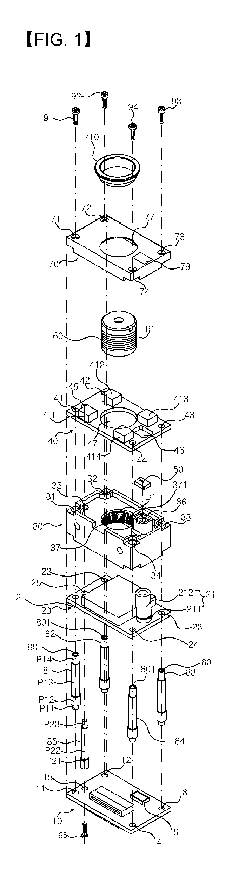

A structure of a barcode engine according to an embodiment will be described with reference to FIG. 1.

The barcode engine according to the embodiment comprises a decoding module 10, an imaging module 20 located above the decoding module 10, a laser diode part 21 placed on the imaging module 20, a housing 30 located above the imaging module 20, a light emitting diode (LED) module 40 located above the housing 30, a plurality of light-emitting-diode parts 411 to 414 placed on the light-emitting diode module 40, a diffractive-optical-element (DOE) pattern part 50 located above the housing 30, a lens part 60 placed on the imaging module 20, a cover 70 located above the light-emitting diode module 40, a rubber ring 701 placed on the cover 70, first to fifth guide pins 81 to 85 that physically and electrically connect the modules 10, 20, and 40 with the housing 30, a plurality of screws 91 to 94 that are inserted into the guide pins 81 to 84 to be fastened to the associated guide pins 81 to 84, and a screw 95 that is inserted into the remaining guide pin 85 to be fastened to the associated guide pin 85.

The decoding module 10 interprets information contained in the barcode using an image signal obtained from the imaging module 20.

Such a decoding module 10 has the shape of a tetragon, namely, a rectangle, and has on an edge portion thereof a plurality of first openings 11 to 15 into which the plurality of guide pins 81 to 85 is inserted, and a slim stack connector 16 electrically connected with the plurality of first openings 11 to 15.

Some of first openings 11 to 14 are located at four corners of the decoding module 10, and a remaining opening 15 is located adjacent to the screw 11 while being separated therefrom.

The imaging module 20 is provided with a CMOS image sensor.

Thus, the imaging module 20 is a module that changes an image, formed when light reflected from the subject barcode passes through the lens part 60 and reaches the image sensor, into an electric signal of an associated intensity depending on a light intensity, obtains an image signal for the captured barcode, and then transmits the image signal to the decoding module 10.

Such an imaging module 20 also has the shape of a rectangle, and has a plurality of second openings 21 to 25 at positions corresponding to the plurality of first openings 11 to 15 that are formed in the decoding module 10, and a slim stack connector (not shown) located at a position to face the slim stack connector 16 of the decoding module 10.

As such, since the slim stack connectors located at corresponding positions of the decoding module 10 and the imaging module 20 allow a signal to be transmitted between the decoding module 10 and the imaging module 20 in a stacking direction, namely, a vertical direction, it is easy to stack the barcode engine in a vertical direction, in addition to realizing the miniaturization of the barcode engine.

Moreover, a signal transmission distance between the decoding module 10 and the imaging module 20 is shortened, so that a negative influence such as noise is reduced and thereby signal transmission efficiency is improved.

The laser diode part 21 has a cylindrical shape, and comprises a laser diode (LD) 211 that is located at a lower end adjacent to the imaging module 20 and a reflector 212 that is located above the laser diode 22.

The laser diode 211 radiates a laser beam towards the barcode to allow a user to easily see a photographing range of the barcode.

The reflector 212 is a reflection barrel, and an inner surface thereof is corrugated and is plated with silver (Ag) or the like. Thus, the reflector 212 guides the laser beam to radiate the laser beam from the laser diode 211 in a desired direction without a loss.

The housing 30 is located above the imaging module 20 to protect the imaging module 20 that is provided under the housing.

This housing 30 also comprises a plurality of third openings 31 to 35 at positions corresponding to the plurality of second openings 21 to 25 of the imaging module 20.

Further, in order to protect the imaging module 20, the housing 30 is open at a lower surface thereof to define a space that accommodates the imaging module 20 therein, and is provided with a protruding part 36 having a space to accommodate the laser diode part 21 that is provided on the imaging module 20 to protrude upwards. In addition, the housing 30 has on a central portion thereof a hole through which the lens part 22 passes, namely, a lens insert hole 37.

A protrusion height of the protruding part 36 is set depending on a protrusion height of the laser diode part 21 that protrudes upwards from the imaging module 20.

Here, the laser diode part 21 and the protruding part 36 into which the laser diode part 21 is inserted are not located in the central portions of the imaging module 20 and the housing 30 but are located in the edge portions thereof, respectively.

Thus, in order to radiate the laser beam onto the central portion of the barcode engine, the protruding part 36 is inclined towards the central portion of the housing 30 at a preset angle (e.g. 15 degrees), and the laser diode part 21 may also be inclined towards the central portion of the imaging module 20 in the same inclination angle and inclination direction as the protruding part 36, as necessary.

A screw groove 371 is formed on a side surface of the lens insert hole 37 to insert the lens part 22 therein, so that the screw groove 371 is fastened to a portion of the lens part 22 in a threaded fastening method. Thus, a side height D1 of the lens insert hole 37 on which the screw groove 371 is formed depends on the length of the lens part 22 that is to be fastened in the threaded fastening method.

Since a plurality of light-emitting-diode parts 411 to 414 is mounted on the light-emitting diode module 40, the light-emitting diode module 40 controls the operation of the light-emitting-diode parts 411 to 414. Thus, the light-emitting-diode parts 411 to 424 may be a portion of the light-emitting diode module 40.

The light-emitting diode module 40 also has a rectangular shape, and comprises a plurality of fourth openings 41 to 45 that correspond to the plurality of third openings 31 to 35 formed in the housing 30 positioned under the light-emitting diode module, a protruding hole 46 through which the protruding part 36 of the housing 30 passes, and a lens insert hole 47 that is located to correspond to the lens insert hole 37 of the housing 30 and through which the lens part 60 passes.

The protruding hole 46 has a tetragonal shape like the plane shape of the protruding part 36, and the lens insert hole 47 has a circular shape like the plane shape of the lens part 60.

The plurality of light-emitting-diode parts 411 to 414 serves as an illumination part that radiates light onto the barcode to obtain a clearer barcode image.

Each of the light-emitting-diode parts 411 to 414 comprises red, green, and blue light emitting diodes to output red light, green light, and blue light.

Thus, at least one of the light emitting diodes is driven using a light-emitting-diode drive circuit installed at the light-emitting diode module 40 to radiate light with at least one of red, green, and blue colors towards the barcode for a predetermined period of time.

As such, since the light output from the light-emitting diode module 40 has three colors (i.e., red, green, and blue), the light output by the light-emitting diode module 40 has eight colors.

In order to display at least one of the eight colors, a user selects a desired color in view of characteristics such as a barcode print medium or color and then inputs the selected color into the light-emitting diode module 40.

Thus, a control device configured to control the operation of the light-emitting-diode drive circuit determines a color selected by a user and then controls the operation of the light-emitting-diode drive circuit to turn on light of a selected color depending on conditions set by the user.

As such, since the color of the illumination is changed depending on a material or a color of a product which the barcode is printed on or attached to, it is possible to more precisely obtain the image of the barcode. Consequently, the barcode engine is capable of more rapidly and precisely reading information contained in the barcode.

The diffractive-optical-element pattern part 50 diffracts a laser beam output from the laser light-emitting-diode part 21 and then outputs the laser beam towards the barcode in an aiming pattern that has a shape corresponding to a pattern formed on the diffractive-optical-element pattern part 50.

Since the image located in the aiming pattern is obtained by the imaging module 20, a user may precisely capture the image of a target barcode using the imaging module 20 to read the image of the desired barcode.

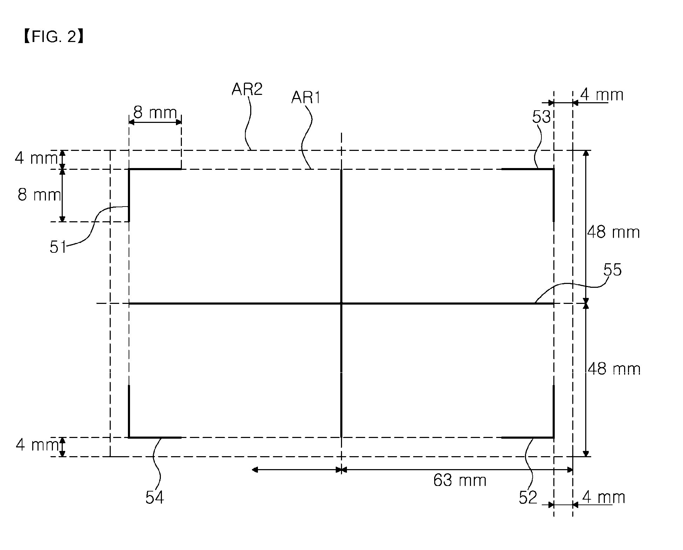

As illustrated in FIG. 2, the aiming pattern of the laser beam that is output from the diffractive-optical-element pattern part 50 according to this embodiment comprises four bracket marks ( 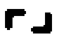 , 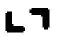 ) 51 to 54 and one cross mark (+) 55. The four bracket marks are shown by solid lines at two corners that diagonally face each other, among four corners of the tetragon. The cross mark is formed by a solid line at a central portion in a rectangular area AR1 that is imaginarily surrounded by the bracket marks 51 to 54.

Here, longitudinal and transverse lengths of each of the bracket marks 51 to 54 are equal to each other, and are 8mm by way of example.

Further, a transverse length of the cross mark 55 is equal to that of the rectangular area AR1, while a longitudinal length of the cross mark is equal to that of the rectangular area AR1.

The area AR1 that is imaginarily formed by the aiming pattern is smaller in size than a light radiation area AR2 onto which light is radiated from the light emitting diode. A difference between the two areas AR1 and AR2 in a longitudinal direction and a difference between the two areas AR1 and AR2 in a transverse direction are equal to each other and are 4mm.

Further, the transverse length of the light radiation area AR2 is 126mm and the longitudinal length thereof is 96mm.

All numerical values for the above-described aiming pattern are values that are obtained when a radiation distance of the laser beam radiated onto the barcode is 150mm, and the area AR1 corresponds to a viewing angle of a lens.

The diffractive-optical-element pattern part 50 radiating the laser beam of the aiming pattern is positioned just above the protruding part 36 of the housing 30 that passes through the protruding hole 46 of the light-emitting diode module 40, and thereby is positioned adjacent to the reflector 212 of the laser diode part 21 located just below the protruding part 35.

Thus, after the laser beam output from the laser diode part 21 is output from the reflector 212, the laser beam passes through the open protruding part 36, is incident on the diffractive-optical-element pattern part 50, and then is output to an associated aiming pattern.

Since the protruding part 36 serves as an optical guide, a loss amount of light incident onto the diffractive-optical-element pattern part 50 is significantly reduced.

The lens part 60 comprises at least one lens for photographing the barcode, and forms a camera assembly that captures the image of the barcode together with the imaging module 20 and then converts the image into an electrical signal.

Such a lens part 60 sequentially passes through the lens insert hole 47 formed in the light-emitting diode module 40 and the lens insert hole 37 formed in the housing 30, and is mounted on the imaging module 20 located under the housing 30 to be connected with the imaging module 20.

Thus, the operation of the lens part 60 is controlled by the operation of the control device located in the imaging module 20 to adjust a focus for photographing the barcode and to concentrate light. Therefore, the lens part 60 may be a portion of the imaging module 20.

As described above, a thread 61 is partially formed on an outer surface of the lens part 60 to be fastened to the screw groove 371 formed in the lens insert hole 37 of the housing 30 in the threaded fastening method, so that the lens part 60 is fastened to the lens insert hole 37 of the housing 30 in the threaded fastening method to be stably fixed in the lens insert hole 37.

The cover 70 is made of plastics, and has a tetragonal shape.

Such a cover 70 has a plurality of fifth openings 71 to 74 at positions corresponding to the fourth openings 41 to 44 of the light-emitting diode module 40 located thereunder, and a lens insert hole 77 located in a central portion thereof.

The lens insert hole 77 is a hole that passes through the cover 70. The lens part 60 is exposed through the lens insert hole 77.

A portion 78 provided on a top of the cover 70 to face the diffractive-optical-element pattern part 50 is made of a light transmissive material that permits the transmission of light, such as transparent plastics, and serves as a window 78 to allow the laser beam to penetrate to the outside. In addition, this portion serves to press the mounted diffractive-optical-element pattern part 50 and thereby prevent the diffractive-optical-element pattern part 50 from being moved.

Therefore, the laser beam is radiated without loss from the diffractive-optical-element pattern part 50 towards the barcode that is located outside.

The rubber ring 701 is inserted into the lens insert hole 77 to surround the lens part 60 that is exposed through the lens insert hole 77, thus protecting the lens part 60 from external shocks and preventing a fixing position of the lens part 60 from being changed.

The plurality of guide pins 81 to 85 each have a cylindrical shape, and are inserted into the first to fourth openings 11 to 15, 21 to 25, 31 to 35 and 41 to 45 that are located in the decoding module 10, the imaging module 20, the housing 30, and the light-emitting diode module 40, respectively, to be connected with the modules 10 to 40.

Each of the guide pins 81 to 85 is plated with gold (Au) and thereby is superior in electrical conductivity. Thus, the guide pins 81 to 85 not only serve as a stacker for sequentially stacking the modules 10 to 40 in the vertical direction but also serve as a signal transmission line for transmitting a required signal between the modules 10 to 40.

Therefore, in the plurality of guide pins 81 to 85, the first guide pin 81 is sequentially inserted into the openings 11, 21, 31, and 41 formed in the respective modules 10 to 40, and is electrically connected with the green light emitting diode that is one of the light-emitting-diode parts 411 to 414 located in the light-emitting diode module 40.

The second guide pin 82 is sequentially inserted into the openings 12, 22, 32, and 42 formed in the respective modules 10 to 40, and supplies power Vcc to the respective modules 10 to 40. The third guide pin 83 is sequentially inserted into the openings 13, 23, 33, and 43 formed in the respective modules 10 to 40, and is electrically connected with the red light emitting diode among the light-emitting-diode parts 411 to 414 located in the light-emitting diode module 40.

Further, the fourth guide pin 84 is sequentially inserted into the openings 14, 24, 34, and 44 formed in the respective modules 10 to 40, and supplies ground voltage GND to the respective modules 10 to 40. The fifth guide pin 85 is in contact with the opening 15 formed in the module 10, is sequentially inserted into the openings 25, 35, and 45 formed in the modules 20, 30, and 40, and is electrically connected with the blue light emitting diode among the plurality of light-emitting-diode parts 411 to 414 located in the light-emitting diode module 40.

For the purpose of transmitting such an electrical signal through the plurality of guide pins 81 to 85, both of inner surfaces of the openings 11 to 15, 21 to 25, 31 to 35, and 41 to 45 into which the respective guide pins 81 to 85 are inserted or which the respective guide pins come into contact, and edge peripheral portions of the openings 11 to 15, 21 to 25, 31 to 35, 41 to 45 are plated with gold (Ag), so that they may be electrically connected with signal lines formed on the associated modules 10 to 40 that are required to be electrically connected with the guide pins 81 to 85. The kind of a signal transmitted through each of the guide pins 81 to 85 may be changed.

As such, since the plurality of guide pins 81 to 85 are plated with gold, heat generated when the respective modules 10 to 40, stacked by sequentially inserting the plurality of guide pins 81 to 85 therein, are operated is dispersed to the plurality of guide pins 81 to 85 connected via gold plated portions and then is dissipated to the outside.

Therefore, since heat generated from each of the modules 10 to 40 is rapidly dispersed through the plurality of guide pins 81 to 85 or dissipated to the outside, the damage to or malfunction of the modules 10 to 40 caused by the heat is prevented.

As illustrated in FIG. 1, four guide pins 81 to 84 of the five guide pins 81 to 85 have the same shape, and the remaining one 85 has a different shape.

The first to fourth guide pins 81 to 84 each have fourth portions P11 to P14 of different diameters.

The first portion P11 located at the lowermost portion has the smallest diameter, so that the first portion P11 is inserted into each of the first openings 11 to 14 formed in the decoding module 10 and then is located in the associated first opening 11 to 14 through soldering or the like.

Since the diameter is reduced from the second portion P12 to the fourth portion P14 in this order, the openings 21 to 24, 31 to 34 and 41 to 45 that are formed in the imaging module 20, the housing module 30, and the light-emitting diode module 40, respectively, are different from each other in diameter.

Due to a diameter difference between adjacent portions P11 to P14 of each of the guide pins 81 to 84 and a diameter difference between the openings 21 to 24, 31 to 34, and 41 to 45, the respective portions P12 to P14 act as the insert prevention step so that the respective modules 10 to 40 are inserted up to the associated portions P11 to P14 and then are fixed to the inserted positions.

That is, the second portion P12 acts as the insert prevention step of the decoding module 10 and the imaging module 20, and the third portion P13 acts as the insert prevention step of the light-emitting diode module 40.

The housing 30 is inserted into the second portion P12 to come into contact with the imaging module 20 located under the housing and the light-emitting diode module 40 located above the housing and thereby protect the imaging module 20 from the outside.

Here, spacing distances between two adjacent modules 10 to 40 are determined depending on the lengths of the respective portions P12 to P14.

A screw groove 801 is formed in the fourth portion P14 that is located at the uppermost portion of each of the guide pins 81 to 84 so that each of the screws 91 to 94 is inserted into and fastened to the screw groove.

Thus, the screws 91 to 94 passing through the fifth openings 71 to 74 formed in the cover 70 are inserted into the screw grooves 801 that are formed in the first to fourth guide pins 81 to 84 and then are fastened to the first to fourth guide pins 81 to 84 in the threaded fastening method.

Unlike the first to fourth guide pins 81 to 84, the fifth guide pin 85 has the first to third portions P21 to P23. The diameter of the first portion P21 located at the lowermost portion is the largest, and the diameter of the third portion P23 located at the uppermost portion is the smallest.

Hence, among the openings 15, 25, 35, and 45 into which the fifth guide pin 85 is inserted, the diameter of the opening 15 formed in the decoding module 10 is the largest, and the diameter of the opening 45 located in the light-emitting diode module 40 is the smallest.

As described above with reference to the first to fourth guide pins 81 to 84, the respective portions P21 to P23 also act as the insert prevention steps of the associated modules 10 to 40, due to such a diameter difference.

Here, the first portion P21 of the fifth guide pin 85 corresponds to the second portion P12 of each of the guide pins 81 to 84, and the second portion P21 of the fifth guide pin 85 corresponds to the third portion P13 of each of the guide pins 81 to 84.

Thus, the first portion P21 acts as the insert prevention step of the imaging module 20, the second portion P22 acts as the insert prevention step of the light-emitting diode module 40, and the housing 30 is inserted into the second portion P22 to come into contact with the imaging module 20 and the light-emitting diode module 40 and thereby protects the imaging module 20 from the outside.

A screw groove 802 is located in a lower end of the first portion P21 of the fifth guide pin 85 so that the screw 95 is inserted into the screw groove.

Therefore, the first portion P21 of the fifth guide pin 85 is located above the associated opening 15 of the decoding module 10, and is fastened to the screw 95 inserted into the opening 15 of the decoding module 10 in the threaded fastening method. After the third portion P23 passes through the associated opening 45 of the light-emitting diode module 40, the third portion P23 is coupled with the light-emitting diode module 40 by soldering or the like.

Hence, the decoding module 10, the imaging module 20, the housing 30 and the light-emitting diode module 50 are stably fixed in positions by the soldering and the screw fastening of the first to fifth guide pins 81 to 85.

When the associated modules 20 to 40 and components 411 to 414, 50, and 70 are mounted between the cover 70 and the decoding module 10 using the plurality of screws 91 to 95, the diffractive-optical-element pattern part 60 located above the protruding part 36 of the housing 30 is stably located at an associated position, namely, above the protruding part 36 by pressure exerted by the operation of fastening the screws 91 to 95 even if there is no separate adhesion process or fixing device using adhesive or soldering.

Therefore, since the separate process or fixing device is not required to fix the diffractive-optical-element pattern part 60 to a predetermined position, the period and cost of manufacturing the imaging part and the decoding part are significantly reduced. The imaging part comrises the imaging module 20, the housing 30, the light-emitting diode module 40, the plurality of light-emitting-diode parts 411 to 414, and the lens part 60 to photograph the barcode, obtain the image of the barcode and then output the image signal corresponding to the obtained image. The decoding part comprises the decoding module 20 to interpret information contained in the barcode using the image signal output from the imaging part.

As such, since the decoding part and the imaging part are connected to each other in a vertical stacking structure using the cylindrical guide pins 81 to 85, an area for installing the decoding part and the imaging part is significantly reduced.

That is, in the related art wherein the decoding part and the imaging part are coupled with each other using the flexible cable, a space larger than that required by the decoding part and the imaging part is needed due to the flexible cable although the decoding part and the imaging part are stacked in a vertical direction.

However, according to this embodiment, when the decoding part and the imaging part are stacked in a vertical direction, the plurality of guide pins 81 to 85 are located in the space occupied by the decoding part and the imaging part. Thus, additional space is not required for the plurality of guide pins 81 to 85.

Further, in the case of using the flexible cable, the associated module electrically connected with the flexible cable is problematic in that a separate connector should be installed in the associated module to be connected with the flexible cable, so that the size of the module is increased.

However, according to this embodiment, since the openings 11 to 15, 21 to 25, 31 to 35, and 41 to 45 into which the plurality of guide pins 81 to 85 are inserted are plated to serve as a connector that is electrically connected with the guide pins 81 to 85, signal transmission between the imaging part and the decoding part is performed using the plurality of guide pins 81 to 85 and the slim stack connector 16.

Therefore, unlike the related art using the flexible cable, it is unnecessary to form the separate connector in the modules 10 to 30, so that the size of the modules 10 to 30 is significantly reduced and the signal transmission efficiency is improved.

Consequently, unlike the related art, according to this embodiment, the size of the barcode engine having the imaging part and the decoding part is determined depending on only the size of the imaging part and the decoding part, so that the size of the barcode engine is significantly reduced as compared to the conventional barcode engine.

Further, when the plurality of components 10 to 50 are sequentially stacked in the vertical direction using the plurality of guide pins 81 to 85, the transverse lengths and the longitudinal lengths of the rectangular components 10 to 50 are substantially equal within an error range.

For example, the transverse length of each of the modules 10 to 40 may be 20.26 mm ± 0.1%, the longitudinal length thereof may be 12.4 mm ± 0.1%, and the thickness of the barcode engine may be 17.2 mm ± 0.1%.

Thus, when the decoding part and the imaging part are combined with each other in the vertical direction, the transverse dimension and the longitudinal dimension thereof do not exceed the sizes of the respective modules 10 to 30 or other components 30 and 70. As a result, it is easy to achieve a reduction in size of the barcode engine.

As illustrated in FIG. 1, the fifth guide pin 85 is connected to the decoding module 10 using the screw 95.

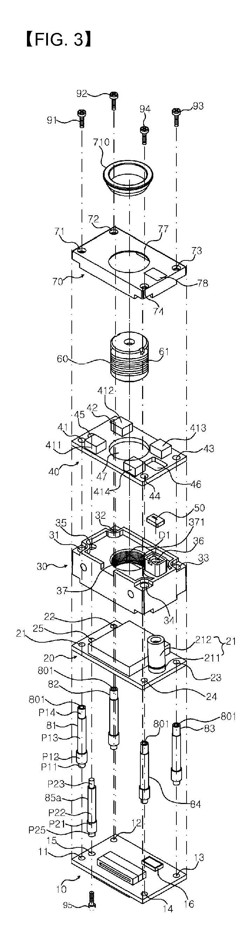

However, in another embodiment illustrated in FIG. 3, a fifth guide pin 85a is connected to the decoding module 10 by soldering or the like as in other guide pins 8184.

To this end, instead of the screw groove 802, an insert portion P25 is formed on a first portion P21a of the fifth guide pin 85a according to this embodiment to be fastened to the associated opening 15.

In this regard, since the insert portion P25 performs the same function as the first portion P11 of each of the first to fourth guide pins 8184, the insert portion P25 is inserted into the associated opening 15 formed in the decoding module 10 and then is fixed to the associated opening 15 through soldering or the like.

Therefore, according to this embodiment, all of the first to fifth guide pins 8185a are fixedly connected to the decoding module 10 through an adhesion operation such as soldering, instead of using fastening means such as a screw.

Except for this difference, the structure and function of the fifth guide pin 85a illustrated in FIG. 3 are the same as the fifth guide pin 85 that has been already described with reference to FIG. 1, so that a detailed description thereof will be omitted.

For the convenience of description, FIGS. 1 and 3 schematically illustrate the structure of each of the modules 10 to 30, so that many components for operating each of the modules 10 to 30, including a plurality of signal lines disposed on upper and lower surfaces of each of the modules 10 to 30, a control chip or a memory device, and electronic parts are omitted.

## Claims

1. A barcode engine comprising:
an imaging part having a plurality of openings and obtaining an image of a barcode by taking a picture thereof to output a corresponding image signal;
a decoding part having a plurality of first openings, located under the imaging part and interpreting information contained in the barcode using the image signal output from the imaging part; and
a plurality of guide pins inserted into or abutting the plurality of first openings formed in the decoding part, and inserted into or abutting the plurality of openings formed in the imaging part, thereby stacking the imaging part on top of the decoding part in a vertical direction.

2. The barcode engine according to claim 1, wherein the plurality of guide pins, the plurality of openings of the imaging part and the plurality of first openings of the decoding part coming into contact with the plurality of guide pins, respectively, are plated with gold, thus sending an electrical signal between the imaging part and the decoding part.

3. The barcode engine according to claim 1, wherein the imaging part comprises:
an imaging module located above the decoding part, the imaging module having a plurality of second openings at positions corresponding to the plurality of first openings of the decoding part, and outputting the image of the barcode in a form of the image signal;
a housing located above the imaging module, the housing having a plurality of third openings at positions corresponding to the plurality of second openings of the imaging module, and protecting the imaging module; and
a light-emitting diode module located above the housing, the light-emitting diode having a plurality of fourth openings at positions corresponding to the plurality of third openings of the housing, and outputting illumination to the barcode,
wherein the plurality of guide pins passes through the plurality of first to fourth openings to sequentially stack the imaging module, the housing, and the light-emitting diode module on the decoding part in a vertical direction.

4. The barcode engine according to claim 3, wherein the plurality of guide pins has different diameters, and comprises a plurality of portions serving as an insert prevention step of the imaging module and the light-emitting diode module.

5. The barcode engine according to claim 3, wherein the decoding part, the imaging module, the housing, and the light-emitting diode module are equal to each other in width and in length.

6. The barcode engine according to claim 3, wherein the light-emitting diode module comprises a plurality of light-emitting-diode parts, and each of the plurality of light-emitting-diode parts comprises a plurality of light emitting diodes that radiate red, green, and blue light, respectively.

7. The barcode engine according to claim 6, wherein the light-emitting diode module turns on at least one of the plurality of light emitting diodes that radiate the red, green, and blue light.

8. The barcode engine according to claim 3, wherein the imaging module comprises a laser diode part to radiate a laser beam, and
the imaging part further comprises a diffractive-optical-element pattern part that is located above the laser diode part and outputs the laser beam, outputted from the laser diode part, in a preset aiming pattern.

9. The barcode engine according to claim 8, wherein the aiming pattern comprises:
four bracket marks shown by solid lines on two corners that diagonally face each other, among four corners of a tetragon; and
one cross mark formed by solid lines at a central portion in a rectangular area that is imaginarily surrounded by the four bracket marks.
